(19) Europäisches Patentamt

European Patent Office

Office européen des brevets

(11) EP 0 477 088 B1

(12) EUROPEAN PATENT SPECIFICATION

(45) Date of publication and mention
of the grant of the patent:
**08.01.1997 Bulletin 1997/02**

(51) Int Cl.6: **H03K 19/003**, H03K 17/14

(21) Application number: **91402469.0**

(22) Date of filing: **17.09.1991**

(54) **Semiconductor integrated circuit having means for suppressing a variation in a threshold level due to temperature variation**

Integrierte Halbleiterschaltung mit Mitteln zur Unterdrückung von temperaturabhängigen Schwellenschwankungen

Circuit semi-conducteur intégré comportant des moyens d'élimination des variations de seuil dues aux variations de température

(84) Designated Contracting States:
**DE FR GB**

(30) Priority: **17.09.1990 JP 246841/90**

(43) Date of publication of application:
**25.03.1992 Bulletin 1992/13**

(73) Proprietor: **FUJITSU LIMITED**
**Kawasaki-shi, Kanagawa 211 (JP)**

(72) Inventors:
• **Endo, Toru, c/o FUJITSU LIMITED**
**Kawasaki-shi, Kanagawa 211 (JP)**
• **Okajima, Yoshinori, c/o FUJITSU LIMITED**
**Kawasaki-shi, Kanagawa 211 (JP)**

(74) Representative: **Joly, Jean-Jacques et al**
**Cabinet Beau de Loménie**
**158, rue de l'Université**
**75340 Paris Cédex 07 (FR)**

(56) References cited:
EP-A- 0 102 643          WO-A-87/03758
WO-A-89/00362          US-A- 4 902 915

• **PATENT ABSTRACTS OF JAPAN vol. 14, no. 12 (E-871)(3955) 11 January 1990 & JP-A-1 256 220**

## Description

BACKGROUND OF THE INVENTION

(1) Field of the Invention

The present invention generally relates to semiconductor integrated circuits and more particularly to a semiconductor integrated circuit having means for suppressing a temperature-related variation in a threshold level.

(2) Description of the Related circuit

Generally, an integrated circuit formed on a semiconductor chip is composed of an input circuit, an internal circuit and an output circuit, as shown in FIG.1A. A common power supply line L is provided in common to the input circuit, the internal circuit and the output circuit. Electricity is supplied to the input circuit, the internal circuit and the output circuit via a pair of power supply lines, one of which is maintained at a high potential and the other one of which is maintained at a low potential. The common power supply line L shown in FIG.1A is one of the pair of power supply lines.

Generally, the output circuit consumes much more energy than the input circuit and the internal circuit. Thus, when a large number of internal elements, such as transistors, executes a switching operation, a large variation occurs in current passing through the output circuit. The above current variation causes a change in potential of the power supply line L. This change in potential of the power supply line L causes various problems in the input circuit and/or the internal circuit.

When the input circuit is composed of CMOS (Complementary Metal Oxide Semiconductor) elements, it includes a CMOS inverter. When the input circuit is composed of a BiCMOS (Bipolar-Metal Oxide Semiconductor) circuit, the input circuit includes a CMOS inverter in the first stage of the BiCMOS circuit.

The CMOS inverter has a threshold level Vth. When an input signal has a level higher than the threshold level Vth, the CMOS inverter outputs a low-level signal. When the input signal has a level lower than the threshold level Vth, the CMOS inverter outputs a high-level signal. The CMOS inverter is composed of a transistor pair: a p-channel MOS transistor (hereafter simply referred to as a pMOS transistor) and an n-channel MOS transistor (hereafter simply referred to as an nMOS transistor), both of which are connected in series.

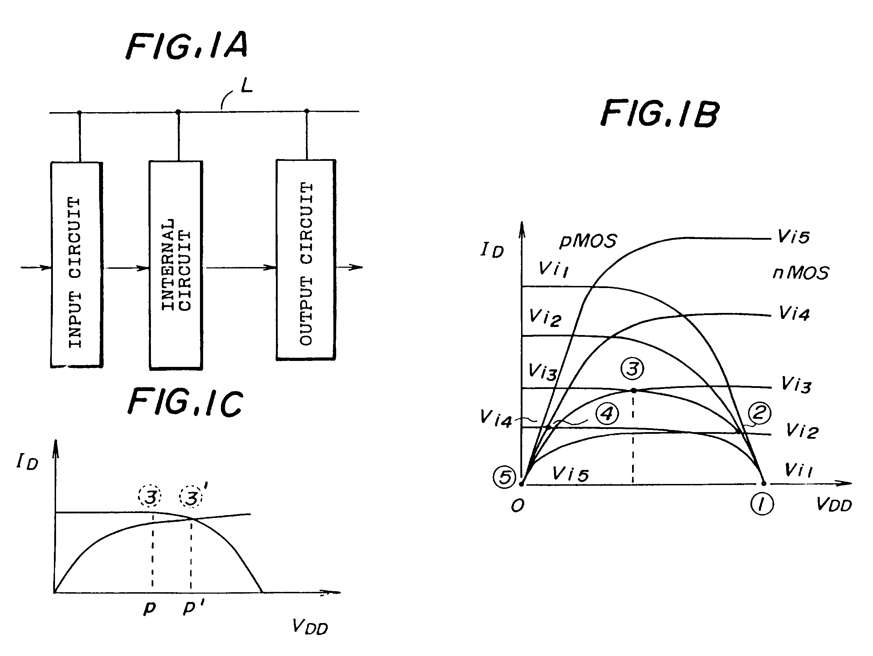

FIG.1B is a graph of drain voltage ($V_{DD}$) vs. drain current ($I_D$) characteristics of the pMOS and nMOS transistors. $V_{i1}$ through $V_{i5}$ are gate voltages of the pMOS and nMOS transistors. Reference numerals ① through ⑤ indicate cross points where the $V_{DD}$-$I_D$ characteristics of the pMOS transistor cross those of the nMOS transistor. At cross point ①, the nMOS transistor is OFF, and the pMOS transistor is ON. At cross point ②, the nMOS transistor operates in a saturated area, and the pMOS transistor operates in a linear area. At cross point ③, both the nMOS and pMOS transistors operate in respective saturated areas. At cross point ④, the nMOS transistor operates in a linear area, and the pMOS transistor operates in the saturated area. At cross point ⑤, the nMOS transistor is ON, and the pMOS transistor is OFF. The threshold level Vth corresponds to a drain voltage obtained at cross point ③. That is, the threshold level Vth corresponds to an identical drain voltage of the pMOS and nMOS transistors when these transistors are in the saturated areas. When the nMOS and pMOS transistors have good complementary characteristics (for example, when $\beta n = \beta p$ and Vthn = Vthp where $\beta n$ and $\beta p$ are, respectively, current transfer ratios of the nMOS and pMOS transistors and Vthn and Vthp are respectively the threshold levels of the nMOS, and the pMOS transistors). The threshold level Vth of the CMOS inverter is equal to $V_{DD}/2$.

The drain current $I_D$ of a MOS transistor when it is in the saturated area can be written as follows:

$$I_D = \beta (Vin - Vth)^2/2$$

$$\beta = \mu CoxW/L$$

where $\beta$ is the current transfer ratio of the MOS transistor, Vin is the input voltage applied to the MOS transistor, $\mu$ is the mobility, Cox is the thickness of an oxide film, W is the width of the gate of the MOS transistor, and L is the length thereof.

The mobility $\mu$ of the MOS transistor decreases as its temperature increases. Hence, as temperature increases, both the current transfer ratio $\beta$ and the drain current $I_D$ decrease. Since the mobility of holes is much greater than that of electrons, diminutions in $\mu$, $\beta$ and $I_D$ of the pMOS transistor due to temperature variations are greater than those of the nMOS transistor. Thus, as shown in FIG.1C, the cross point ③ moves to a cross point ③', and thus, the threshold level Vth of the CMOS inverter increases. This change in the threshold level Vth causes malfunctions of the input circuit.

SUMMARY OF THE INVENTION

It is a general object of the present invention to provide a semiconductor integrated circuit in which the above disadvantage is eliminated.

A more specific object of the present invention is to provide a semiconductor integrated circuit in which a variation in the threshold level of the input circuit due to temperature variations can be suppressed through an improvement in the power supply system.

US 4 902 915 discloses a threshold control circuit which eliminates input trip point variation. There is described a semiconductor integrated circuit comprising :

an input circuit having a CMOS inverter of first and second series-connected transistors having respective gates connected in common at a connection node, the input circuit receiving an input signal at the connection node and emitting an output signal, said input circuit having a threshold level which determines the level of the output signal of the input circuit with respect to the level of the input signal, the threshold level varying as a function of variations of the temperature of the CMOS inverter; an internal circuit receiving said output signal of said input circuit and a first power supply voltage, and power source means, coupled to said input circuit and having an output node, for receiving the first power supply voltage and further receiving at a reference node a reference power supply voltage of a level different from the level of the first power supply voltage, for generating, at the output node, a second power supply voltage having a level which varies, independently of the input signal.

According to the present invention, the power source means comprises an emitter follower circuit that delivers said second power supply voltage from a voltage developed across a first resistor: a first current source delivering a first predetermined current through said first resistor; a second current source delivering through said first resistor a second predetermined current that increases with increasing temperature as a function of a voltage drop developed across a first diode.

BRIEF DESCRIPTION OF THE DRAWINGS

Other objects, features and advantages of the present invention will become more apparent from the following detailed description when read in conjunction with the accompanying drawings, in which:

FIG.1A is a block diagram of a conventional semiconductor integrated circuit;
FIG.1B is a graph of characteristics of pMOS and nMOS transistors which form a CMOS inverter;
FIG.1C is a graph showing a disadvantage of the CMOS inverter;
FIG.2 is a block diagram showing an outline of the present invention;
FIG.3 is a circuit diagram of an input circuit shown in FIG.2; and
FIG.4 is a circuit diagram of a temperature-compensated power source shown in FIG.2.

DESCRIPTION OF THE PREFERRED EMBODIMENT

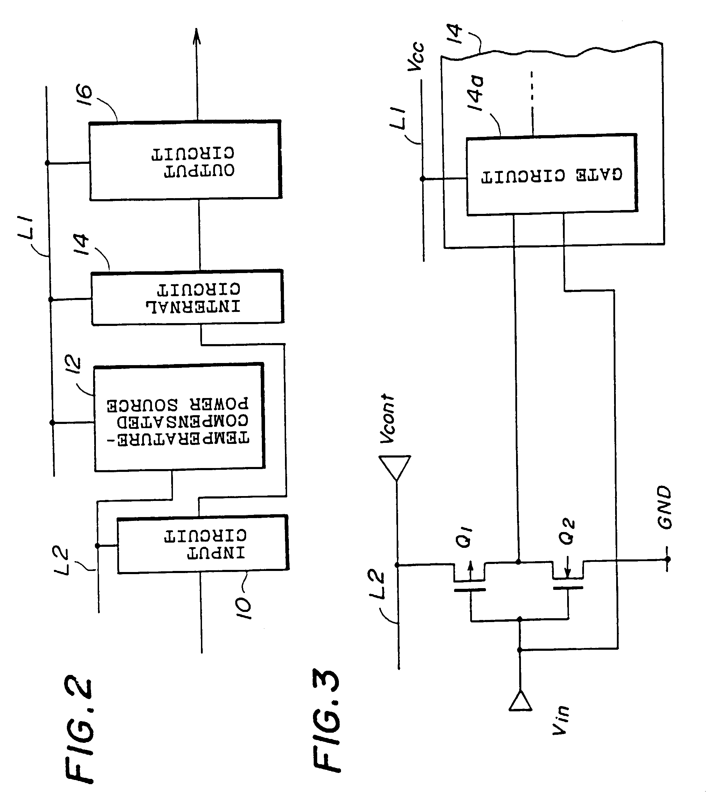

FIG.2 shows an outline of the present invention. An integrated circuit shown in FIG.2 is composed of an input circuit 10, a temperature-compensated power source 12, an internal circuit 14 and an output circuit 16. The temperature-compensated power source 12, the internal circuit 14 and the output circuit 16 are commonly connected to a power supply line L1, which is maintained at a first power supply voltage $V_{CC}$ (potential with respect to a ground level). The temperature-compensated power source 12 generates a second power supply voltage Vcont which is immune to temperature variations. That is, the second power supply voltage Vcont is constant even when the first power supply voltage $V_{CC}$ changes due to a temperature variation. The internal circuit 14 is, for example, a memory cell array, a logic circuit, a gate array, a standard cell array or the like. The output circuit 16 includes, for example, a driving circuit for amplifying a signal from the internal circuit 14 and outputting an amplified signal to a next-stage circuit or an external device.

As shown in FIG.3, the input circuit 10 includes a CMOS inverter composed of a pMOS transistor Q1 and an nMOS transistor Q2, both which are connected in series between the power supply line L2 and the ground. An input voltage Vin is applied to the gates of the pMOS and nMOS transistors Q1 and Q2. An output voltage of the CMOS inverter is applied, together with the input voltage Vin, to a gate circuit 14a of the internal circuit 14. As has been described previously, the threshold of the CMOS inverter increases as the temperature increases. The second power supply voltage Vcont generated by the temperature-compensated power source 12 decreases as the temperature increases.

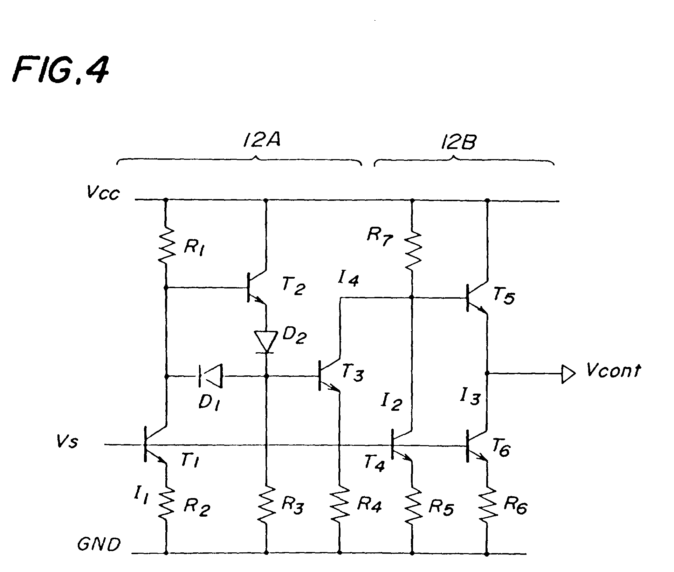

FIG.4 is a circuit diagram of the temperature-compensated power source 12 shown in FIG.2. As shown in FIG.4, the temperature-compensated power source 12 is composed of a temperature compensating block 12A and a voltage setting block 12B. The temperature compensating block 12A is comprised of transistors T1, T2 and T3, diodes D1 and D2 and resistors R1, R2, R3 and R4. The voltage setting block 12B is composed of transistors T4, T5 and T6, and resistors R5, R6 and R7.

The transistor T1 and the resistor R2 form a constant-current source, which generates a constant current I1 based on the resistor R2 and a fixed voltage Vs from an external circuit. The transistor T4 and the resistor R5 form a constant-current source, which generates a constant current I2 based on the resistor R5 and the fixed voltage Vs. The transistor T6 and the resistor R6 form a constant-current source, which generates a constant current I3 based on the resistor R6 and the fixed voltage Vs.

A current passes from the power supply line L1 ($V_{CC}$) to a ground line (having the ground level GND) via the resistor R1, the base and emitter of the transistor T2, the diode D2, the base and emitter of the transistor T3 and the resistor R4. Thus, the transistors T2 and T3 are ON, and a current I4 passes from the power supply line L1 to the ground line via the resistor R7, the transistor T3 and the resistor R4. At this time, a voltage drop is developed across the resistor R7 due to the currents I2 and I4 and the base current of the transistor T5. The output voltage Vcont is equal to the voltage obtained by subtracting from the power supply voltage $V_{CC}$, the sum of the voltage drop developed across the resistor R7, and the base-emitter voltage $V_{BE}$ of the transistor T5 (equal to about 0.8V).

For example, $V_{CC}$ = 5.2V, R1 = 14k$\Omega$, I1 = 0.2mA and I2 = 0.04mA. When $V_{BE} \fallingdotseq$ 0.8V and the voltage drop of the diode D2 is $\fallingdotseq$ 0.8V, the emitter of the transistor T3 has a potential of OV. In this state, there is less current passing through the transistor T3 even though the transistor T3 is ON. Thus, normally, the base potential of the transistor T5, that is, the output voltage Vcont is determined by the current I2 and the resistor R7.

The diode D2 has a voltage drop $V_F$ (junction potential) equal to about 0.8V in the ON state. The voltage drop $V_F$ of the diode D2 decreases as the temperature increases. Thus, the current passing from the Dower supply line L1 to the ground line via R1, T2, D2, T3 and R4 increases as the temperature increases, and thus the transistor T3 increases the current I4. Thus, the voltage drop developed across the resistor R7 increases, and the output voltage Vcont decreases. The magnitude of the decrease in the output voltage Vcont can be adjusted by the collector current I4 and the resistor R7. In the manner described above, it becomes possible to suppress an increase in the threshold level Vth of the input circuit 10 due to an increase in the temperature.

It can be seen from FIG.1C that the threshold level Vth of the input circuit 10 can be adjusted by adjusting the power supply voltage Vcont applied to the input circuit 10. That is, although the cross point ③ tends to move to the cross point ③, when the temperature increases, because the power supply voltage Vcont decreases as the temperature increases, a decrease in the power supply voltage Vcont prevents the cross point ③ from moving to the cross point ③. In this manner it becomes possible to maintain the position of the cross point ③ even though the temperature changes.

**Claims**

1.  A semiconductor integrated circuit comprising :

    -   an input circuit (10) having CMOS inverter (Q1, Q2) and receiving an input signal, said input circuit having a threshold level (Vth) which determines an output level of the input circuit with respect to the input signal; and
    -   an internal circuit (14) receiving said input signal via said input circuit, said internal circuit receiving a first power supply voltage (Vcc);
    -   power source means (12) coupled to said input circuit for generating a second power supply voltage (Vcont) applied to said input circuit so that said second power supply voltage changes to cancel a change in the threshold level due to a temperature variation;

        characterized in that said power source means (12) is comprised of an emitter follower circuit (T5) that delivers said second power supply voltage (Vcont) from a voltage developed across a first resistor (R7);

a first current source (T4, R5) delivering a first predetermined current through said first resistor (R7);
a second current source (D2, T3, R4) delivering through said first resistor a second predetermined current that increases with increasing temperature as a function of a voltage drop developed across a first diode (D2).

2.  A semiconductor integrated circuit as claimed in claim 1, characterized in that said power source means increases the second power supply voltage (Vcont) as the temperature decreases and decreases the second power supply voltage (Vcont) as the temperature increases.

3.  A semiconductor integrated circuit as claimed in claim 1, characterized in that said emitter follower circuit comprises:

    a transistor (T5) having a collector receiving said first power supply voltage, an emitter at which said second power supply voltage is obtained, and a base, whereby the voltage developed across said first resistor is applied to the base of said transistor as a base voltage so that the base voltage changes due to the temperature variation responsive to variations in temperature of the CMOS inverter.

4.  A semiconductor integrated circuit as claimed in claim 3, characterized in that the base voltage is generated such that the base voltage decreases as the temperature increases.

5.  A semiconductor integrated circuit as claimed in claim 1, characterized in that said power source means comprises:

    a first transistor (T2) having a collector receiving said first power supply voltage, a base and an emitter;
    a third constant-current source (T1, R2) connected between the base of said first transistor and the reference node set at the reference voltage, which is lower than said first power supply voltage;
    a third resistor (R1) connected between the collector and base of said first transistor;
    said first diode (D2) having an anode connected to the emitter of said first transistor and a cathode;
    a second transistor (T3) having a base connected to the cathode of said first diode, a collector and an emitter connected through a conductive path to the reference node;
a second resistor (R3) coupled between the base of said second transistor and said reference node;
a third transistor (T5) having a collector receiving said first power supply voltage, a base connected to the collector of said second transistor, and an emitter at which said second power supply voltage is obtained;
said first resistor (R7) connected between the collector and base of said third transistor;
said first constant-current source (T4, R5) connected between the base of said third transistor and said reference node; and
a fourth constant-current source (T6, R6) connected between the emitter of said third transistor and said reference node.

6. A semiconductor integrated circuit as claimed in claim 5, characterized in that said power source means comprises a second diode (D1) having an anode connected to the cathode of said first diode, and a cathode connected to the base of said first transistor.

7. A semiconductor integrated circuit as claimed in claim 6, characterized in that said first, third and fourth constant-current sources have respective terminals receiving a common control voltage (Vs) which determines the amounts of constant currents respectively generated by said first, third and fourth constant-current sources.

8. A semiconductor integrated circuit as claimed in claim 1, characterized by further comprising an output circuit (16) amplifying an output signal from said internal circuit, said output circuit receiving said first power supply voltage ($V_{CC}$).

9. A semiconductor integrated circuit as claimed in claim 1, characterized in that said second power supply voltage (Vcont) is lower than said first power supply voltage ($V_{CC}$).

**Patentansprüche**

1. Integrierte Halbleiterschaltung mit:

- einer Eingangsschaltung (10), die einen CMOS-Inverter (Q1, Q2) hat und ein Eingangssignal empfängt, welche Eingangsschaltung einen Schwellenpegel (Vth) hat, der einen Ausgangspegel der Eingangsschaltung bezüglich des Eingangssignals bestimmt; und
- einer internen Schaltung (14), die das Eingangssignal durch die Eingangsschaltung empfängt, welche interne Schaltung eine erste Energiezuführspannung ($V_{CC}$) empfängt;
- einem Energiequellenmittel (12), das mit der Eingangsschaltung gekoppelt ist, zum Erzeugen einer zweiten Energiezuführspannung (Vcont), die auf die Eingangsschaltung angewendet wird, so, daß sich die zweite Energiezuführspannung verändert, um eine Veränderung des Schwellenpegels auf Grund einer Temperaturschwankung zu unterdrücken;

dadurch gekennzeichnet, daß das Energiequellenmittel (12) eine Emitterfolgerschaltung (T5) umfaßt, die die zweite Energiezuführspannung (Vcont) aus einer Spannung liefert, die sich quer über einen ersten Widerstand (R7) entwickelt;

eine erste Stromquelle (T4, R5) durch den ersten Widerstand (R7) einen ersten vorbestimmten Strom liefert;
eine zweite Stromquelle (D2, T3, R4) durch den ersten Widerstand einen zweiten vorbestimmten Strom liefert, der mit zunehmender Temperatur als Funktion eines Spannungsabfalls, der sich quer über eine erste Diode (D2) entwikkelt, zunimmt.

2. Integrierte Halbleiterschaltung nach Anspruch 1, dadurch gekennzeichnet, daß das Energiequellenmittel die zweite Energiezuführspannung (Vcont) erhöht, wenn die Temperatur abnimmt, und die zweite Energiezuführspannung (Vcont) verringert, wenn die Temperatur zunimmt.

3. Integrierte Halbleiterschaltung nach Anspruch 1, dadurch gekennzeichnet, daß die Emitterfolgerschaltung umfaßt:

einen Transistor (T5), mit einem Kollektor, der die erste Energiezuführspannung empfängt, einem Emitter, an dem die zweite Energiezuführspannung erhalten wird, und einer Basis, wodurch die Spannung, die sich quer über den ersten Widerstand entwickelt, auf die Basis des genannten Transistors als Basisspannung angewendet wird, so daß sich die Basisspannung auf Grund der Temperaturschwankung als Reaktion auf Temperaturschwankungen des CMOS-Inverters verändert.

4. Integrierte Halbleiterschaltung nach Anspruch 3, dadurch gekennzeichnet, daß die Basisspannung so erzeugt wird, daß die Basisspannung abnimmt, wenn die Temperatur zunimmt.

5. Integrierte Halbleiterschaltung nach Anspruch 1, dadurch gekennzeichnet, daß das Energiequellenmittel umfaßt:

einen ersten Transistor (T2), mit einem Kollektor, der die erste Energiezuführspannung empfängt, einer Basis und einem Emitter;

eine dritte Konstantstromquelle (T1, R2), die zwischen der Basis des ersten Transistors und dem Referenzknoten, der auf die Referenzspannung eingestellt ist, die niedriger als die erste Energiezuführspannung ist, verbunden ist;

einen dritten Widerstand (R1), der zwischen dem Kollektor und der Basis des ersten Transistors verbunden ist;

die erste Diode (D2), mit einer Anode, die mit dem Emitter des ersten Transistors verbunden ist, und einer Kathode;

einen zweiten Transistor (T3), mit einer Basis, die mit der Kathode der ersten Diode verbunden ist, einem Kollektor und einem Emitter, der durch einen leitfähigen Weg mit dem Referenzknoten verbunden ist;

einen zweiten Widerstand (R3), der zwischen der Basis des zweiten Transistors und dem Referenzknoten gekoppelt ist;

einen dritten Transistor (T5), mit einem Kollektor, der die erste Energiezuführspannung empfängt, einer Basis, die mit dem Kollektor des zweiten Transistors verbunden ist, und einem Emitter, an dem die zweite Energiezuführspannung erhalten wird;

den ersten Widerstand (R7), der zwischen dem Kollektor und der Basis des dritten Transistors verbunden ist;

die erste Konstantstromquelle (T4, R5), die zwischen der Basis des dritten Transistors und dem Referenzknoten verbunden ist; und

eine vierte Konstantstromquelle (T6, R6), die zwischen dem Emitter des dritten Transistors und dem Referenzknoten verbunden ist.

6. Integrierte Halbleiterschaltung nach Anspruch 5, dadurch gekennzeichnet, daß das Energiequellenmittel eine zweite Diode (D1) umfaßt, mit einer Anode, die mit der Kathode der ersten Diode verbunden ist, und einer Kathode, die mit der Basis des ersten Transistors verbunden ist.

7. Integrierte Halbleiterschaltung nach Anspruch 6, dadurch gekennzeichnet, daß die ersten, dritten und vierten Konstantstromquellen jeweilige Anschlüsse haben, die eine gemeinsame Steuerspannung (Vs) empfangen, die die Beträge von Konstantströmen bestimmt, die jeweilig durch die ersten, dritten und vierten Konstantstromquellen erzeugt werden.

8. Integrierte Halbleiterschaltung nach Anspruch 1, dadurch gekennzeichnet, daß sie ferner eine Ausgangsschaltung (16) umfaßt, die ein Ausgangssignal von der internen Schaltung verstärkt, welche Ausgangsschaltung die erste Energiezuführspannung ($V_{CC}$) empfängt.

9. Integrierte Halbleiterschaltung nach Anspruch 1, dadurch gekennzeichnet, daß die zweite Energiezuführspannung (Vcont) niedriger als die erste Energiezuführspannung ($V_{CC}$) ist.

**Revendications**

1. Circuit intégré à semiconducteur comprenant :

un circuit d'entrée (10) possédant un inverseur CMOS (Q1, Q2) et recevant un signal d'entrée, ledit circuit d'entrée ayant un niveau de seuil (Vth) qui détermine le niveau de sortie du circuit d'entrée par rapport au signal d'entrée ; et
un circuit interne (14) recevant ledit signal d'entrée via ledit circuit d'entrée, ledit circuit interne recevant une première tension d'alimentation électrique ($V_{CC}$),
un moyen formant une source d'alimentation électrique (12) couplé audit circuit d'entrée afin de produire une deuxième tension d'alimentation électrique (Vcont) appliquée audit circuit d'entrée de façon que ladite deuxième tension d'alimentation électrique varie dans un sens propre à annuler la variation du niveau de seuil due à une variation de température ;

caractérisé en ce que ledit moyen formant une source d'alimentation électrique (12) comprend un circuit à montage en émetteur suiveur (T5) qui délivre ladite deuxième tension d'alimentation électrique (Vcont) à partir de la tension créée aux bornes d'une première résistance (R7) ;

une première source de courant (T4, R5) délivrant un premier courant prédéterminé via ladite première résistance (R7) ;
une deuxième source de courant (D2, T3, R4) délivrant, via ladite première résistance, un deuxième courant prédéterminé qui augmente lorsque la température augmente en fonction d'une chute de tension créée aux bornes d'une première diode (D2).

2. Circuit intégré à semiconducteur selon la revendication 1, caractérisé en ce que ledit moyen formant une source d'alimentation électrique augmente la deuxième tension d'alimentation électrique (Vcont) lorsque la température diminue et diminue la deuxième tension d'alimentation électrique (Vcont) lorsque la température augmente.

3. Circuit intégré à semiconducteur selon la revendication 1, caractérisé en ce que ledit circuit à montage en émetteur suiveur comprend :

un transistor (T5) possédant un collecteur qui reçoit ladite première tension d'alimentation électrique, un émetteur sur lequel ladite deuxième tension d'alimentation électrique est obtenue, et une base, de sorte que la tension créée aux bornes de ladite première résistance est appliquée à la base dudit transistor au titre de tension de base de façon que la tension de base varie du fait de la variation de la température en réponse aux variations de température de l'inverseur CMOS.

4. Circuit intégré à semiconducteur selon la revendication 3, caractérisé en ce que la tension de base est produite de façon que la tension de base diminue lorsque la température augmente.

5. Circuit intégré à semiconducteur selon la revendication 1, caractérisé en ce que ledit moyen formant une source d'alimentation électrique comprend :

un premier transistor (T2), possédant un collecteur qui reçoit ladite première tension d'alimentation électrique, une base et un émetteur ;
un troisième source de courant constant (T1, R2), connectée entre la base dudit premier transistor et le noeud de référence fixé à la tension de référence, laquelle est inférieure à ladite première tension d'alimentation électrique ;
une troisième résistance (R1), connectée entre le collecteur et la base dudit premier transistor ;
ladite première diode (D2), possédant une anode qui est connectée à l'émetteur dudit premier transistor et une cathode ;
un deuxième transistor (T3), possédant une base qui est connectée à la cathode de ladite première diode, un collecteur et un émetteur qui est connecté via un trajet conducteur au noeud de référence ;
une deuxième résistance (R3), couplée entre la base dudit deuxième transistor et ledit noeud de référence ;
un troisième transistor (T5), possédant un collecteur qui reçoit ladite première tension d'alimentation électrique, une base qui est connectée au collecteur dudit deuxième transistor, et un émetteur sur lequel ladite deuxième tension d'alimentation électrique est obtenue ;
ladite première résistance (R7), connectée entre l'émetteur et la base dudit troisième transistor;
ladite première source de courant constant (T4, R5), connectée entre la base dudit troisième transistor et ledit noeud de référence ; et
une quatrième source de courant constant (T6, R6), connectée entre l'émetteur dudit troisième transistor et ledit noeud de référence.

6. Circuit intégré à semiconducteur selon la revendication 5, caractérisé en ce que ledit moyen formant une source d'alimentation électrique comprend une deuxième diode (D1) possédant une anode qui est connectée à la cathode de ladite première diode et une cathode qui est connectée à la base dudit premier transistor.

7. Circuit intégré à semiconducteur selon la revendication 6, caractérisé en ce que lesdites première, troisième et quatrième sources de courant constant ont des bornes respectives recevant une tension de commande commune (Vs) qui détermine les intensités des courants constants respectivement produits par lesdites première, troisième et quatrième sources de courant constant.

8. Circuit intégré à semiconducteur selon la revendication 1, caractérisé en ce qu'il comprend en outre un circuit de sortie (16) amplifiant le signal de sortie dudit circuit interne, ledit circuit de sortie recevant ladite première tension d'alimentation électrique ($V_{CC}$).

9. Circuit intégré à semiconducteur selon la revendication 1, caractérisé en ce que ladite deuxième tension d'alimentation électrique (Vcont) est inférieure à ladite première tension d'alimentation électrique ($V_{CC}$).

FIG.IB

FIG.IA

FIG.IC

# FIG.2

```
                    L2
                   ┌────
          ┌──────────┐
          │  INPUT   │
    10────│ CIRCUIT  │
          └──────────┘
              │
      12      │
     ┌──────────────┐
     │ TEMPERATURE- │
     │ COMPENSATED  │
     │ POWER SOURCE │
     └──────────────┘
              │        L1
       14     │      ┌────
     ┌──────────────┐
     │   INTERNAL   │
     │   CIRCUIT    │
     └──────────────┘
              │
       16     │
     ┌──────────────┐
     │    OUTPUT    │──────►
     │   CIRCUIT    │
     └──────────────┘
```

# FIG.3

```
                              L1
                            ┌──── Vcc
                     14a
                   ┌──────────────┐    14
        Vcont      │     GATE     │
         ▽         │   CIRCUIT    │ ⋯
         │         └──────────────┘
    L2   │            │        │
   ┌─────┼────────────┘        │
         │  Q1                 │
         │ ┌┤                  │
         │ ┤├─┐    Q2          │
         │ └┤ │  ┌┤            │
         │    │  ┤├─┐          │
         └────┴──┤├─┴──────────┘──── GND
                 └┤ │
                  │
                  ▽
                 Vin
```

FIG.4